# FASCICULE DE BREVET EUROPEEN

(11) **EP 1 052 779 B1**
(45) Date de publication et mention de la délivrance du brevet: **04.08.2004**
(21) Numéro de dépôt: 00201578.2
(22) Date de dépôt: 02.05.2000
(51) Int. Cl.: H03L 7/00

(54) **Processeur ayant une fréquence de fonctionnement adaptable**
Prozessor mit einer adaptiven Betriebsfrequenz
Processor having adaptable operating frequency

(30) Priorité: 11.05.1999 FR 9906019
(43) Date de publication de la demande: 15.11.2000
(73) Titulaire: Koninklijke Philips Electronics N.V., 5621 BA Eindhoven (NL)
(72) Inventeur: Dujardin, Eric, Société Civile S.P.I.D., 75008 Paris (FR); Gay-Bellile, Olivier, Société Civile S.P.I.D., 75008 Paris (FR)
(74) Mandataire: de la Fouchardière, Marie-Noelle

(56) Documents cités:
- EP-A- 0 512 619
- US-A- 4 612 573
- US-A- 4 617 599
- US-A- 4 797 845

## Description

L'invention concerne un système de communication comportant au moins un émetteur et un récepteur, ledit récepteur comportant:
- un convertisseur analogique - numérique pour échantillonner un signal d'entrée à un rythme fourni par une horloge d'échantillonnage,
- un processeur pour traiter des données échantillonnées, à un rythme fourni par une horloge de fonctionnement,
- un générateur d'horloge pour générer ladite horloge de fonctionnement en fonction de l'horloge d'échantillonnage.

L'invention concerne également:
- un récepteur,
- et un dispositif de traitement de données numériques préalablement échantillonnées à un rythme fourni par une horloge d'échantillonnage, qui comporte un générateur d'horloge pour générer en fonction de ladite horloge d'échantillonnage une horloge de fonctionnement destinée à être utilisée pour traiter lesdites données.

Le brevet américain n° 4,617,599 décrit un équipement électronique doté d'un processeur de traitement de données numériques. Ce processeur est capable de traiter des données échantillonnées avec une fréquence faisant partie d'un ensemble fini de fréquences déterminées. La solution proposée dans ce document consiste à utiliser un oscillateur local spécifique pour chaque fréquence d'échantillonnage susceptible d'être traitée par le processeur. Chaque oscillateur local produit un signal de référence. Un circuit de sélection sélectionne un signal de référence en fonction de la fréquence d'échantillonnage des données à traiter. Le signal de référence sélectionné sert à produire le signal d'horloge utilisé par le processeur pour le traitement des données.

L'invention a pour but de fournir à un processeur une horloge de fonctionnement pour traiter des données échantillonnées avec une horloge d'échantillonnage dont la fréquence peut avoir diverses valeurs non connues à priori. Les fréquences d'échantillonnage susceptibles d'être utilisées n'étant pas connues à priori, la solution proposée dans le brevet américain n° 4,617,599 n'est pas applicable.

Un système de communication, un récepteur et un dispositif de traitement selon l'invention, et tels que décrits dans le paragraphe introductif, sont caractérisés en ce que ledit générateur comporte des moyens pour générer ladite horloge de fonctionnement à partir d'une horloge de base, de manière à ce que ladite horloge de fonctionnement ait un nombre entier constant de périodes actives pendant un cycle de l'horloge d'échantillonnage.

L'invention consiste donc à générer, à partir d'une unique horloge de base, une horloge de fonctionnement qui présente une relation constante avec une horloge d'échantillonnage. Ceci permet notamment au processeur de savoir quand les données échantillonnées sont disponibles dans un référentiel de temps fourni par son horloge de fonctionnement.

L'invention sera mieux comprise et d'autres détails apparaîtront dans la description qui va suivre en regard des dessins annexés qui sont donnés à titre d'exemple non limitatifs et dans lesquels:
- la figure 1 représente un récepteur selon l'invention,
- la figure 2 est un diagramme représentant les différents signaux utilisés dans un système selon l'invention,
- la figure 3 est un schéma d'un exemple de générateur d'horloge selon l'invention,
- la figure 4 est un schéma d'un système communication selon l'invention.

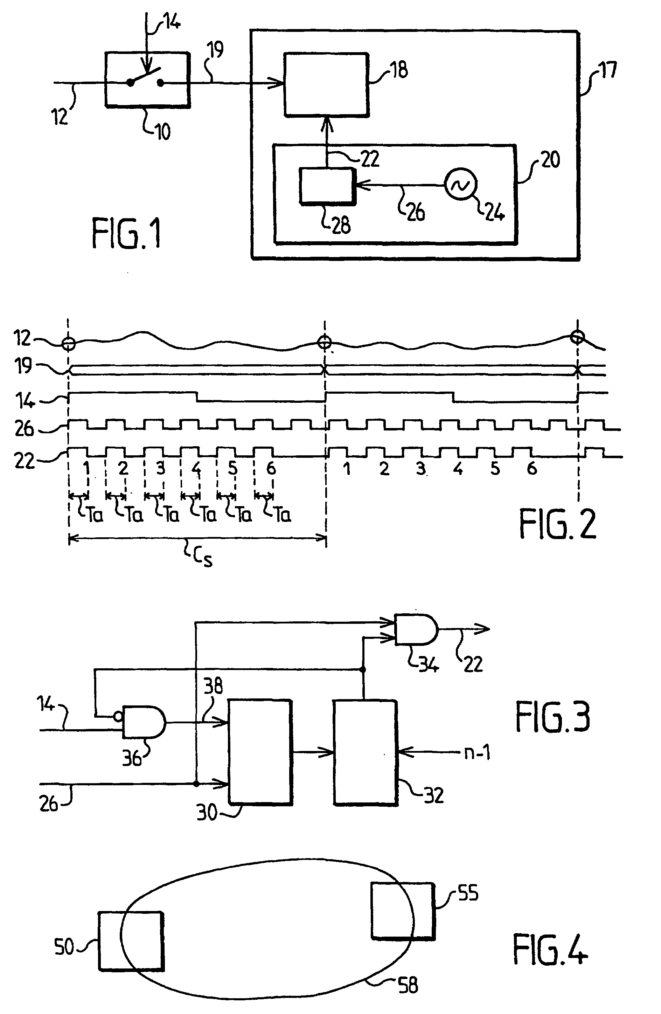

Sur la figure 1 on a représenté un exemple de récepteur selon l'invention. Ce récepteur comporte un convertisseur analogique - numérique 10 pour échantillonner un signal d'entrée 12 à un rythme fourni par une horloge d'échantillonnage 14. Il comporte également un dispositif de traitement 17. Ce dispositif de traitement 17 comporte notamment un processeur 18 pour traiter les données échantillonnées 19, et un générateur d'horloge 20 qui génère une horloge de fonctionnement 22 pour le processeur 18. Cette horloge de fonctionnement 22 est fonction de horloge d'échantillonnage avec laquelle les données à traiter ont été échantillonnées. Conformément à l'invention, le générateur d'horloge 20 comporte un oscillateur local 24 qui fournit une horloge de base 26, et des moyens 28 pour générer horloge de fonctionnement 22 à partir de cette horloge de base 26 de telle sorte que l'horloge de fonctionnement 22 ait un nombre entier constant de périodes actives pendant un cycle de l'horloge d'échantillonnage 14 (dans toute la description, on appelle période active l'espace de temps pendant lequel le niveau de l'horloge de fonctionnement est actif, à l'intérieur d'un cycle de l'horloge de fonctionnement).

L'invention permet d'établir une relation entre l'horloge de fonctionnement 22 du processeur 18 et l'horloge d'échantillonnage 14 des données à traiter, quelle que soit cette horloge d'échantillonnage. Grâce à cette relation constante, le processeur 18 sait qu'il reçoit une donnée échantillonnée tous les n périodes actives de son horloge de fonctionnement 22. Cela permet d'assurer une synchronisation entre l'horloge d'échantillonnage 14 et l'horloge de fonctionnement 22.

Sur la figure 2 on a représenté sous forme de diagramme les différents signaux utilisés dans un système selon l'invention : le signal analogique d'entrée 12, les données échantillonnées 19, l'horloge d'échantillonnage 14, horloge de base 26, et l'horloge de fonctionnement 22. Comme cela apparaît sur la figure 2, il n'existe aucune relation entre l'horloge de base 26 et l'horloge d'échantillonnage 14. L'invention permet de générer à partir de ces deux horloges 14 et 26 une horloge de fonctionnement 22 qui présente une relation constante avec l'horloge d'échantillonnage 14. Conformément à l'invention l'horloge de fonctionnement 22 présente un nombre entier constant n de périodes actives Tₐ pendant un cycle Cₛ de l'horloge d'échantillonnage 14. Le nombre entier n est par exemple défini de la façon suivante : n=E(F_{b} /Fₛ ) où E est la fonction mathématique partie entière, F_{b} est la fréquence de l'horloge de base 26, Fₛ est la fréquence de l'horloge d'échantillonnage 14 et n est un nombre entier constant. Sur la figure 2, on a représenté à titre d'exemple le cas où n=6.

Le processeur 18 est par exemple un processeur programmable destiné à être utilisé pour des applications de démodulation dans un système de diffusion de programmes de télévision numériques du type de ceux définis dans les projets de normes DVB (de l'anglais Digital Video Broadcasting) de l'ETSI. En supposant que:
- l'horloge de base du processeur est fixée à 130 MHz,
- la fréquence d'échantillonnage utilisée dans un démodulateur pour un système de diffusion par satellite est égale à 65 MHz,
- et la fréquence d'échantillonnage utilisée dans un démodulateur pour système de diffusion par câble est égale à 28,92 MHz,
alors, l'horloge de fonctionnement du processeur comporte n=2 périodes actives pendant un cycle de l'horloge d'échantillonnage dans le cas du satellite, et n=4 périodes actives pendant un cycle de horloge d'échantillonnage dans le cas du câble.

Sur la figure 3 on a représenté un exemple de réalisation du générateur d'horloge 20. Le générateur d'horloge de la figure 3 comporte un compteur 30, un comparateur 32, et deux portes logiques 34 et 36 qui sont des portes ET. La porte 34 reçoit en entrée l'horloge de base 26 et la sortie du comparateur 32. Elle délivre en sortie horloge de fonctionnement 22. La porte 36 reçoit en entrée l'horloge d'échantillonnage 14 et l'inverse de la sortie du comparateur 32. Elle délivre un signal 38 de réinitialisation du compteur 30. Le compteur 30 compte les fronts actifs de l'horloge de base 26. Le compteur 30 est réinitialisé lorsque l'horloge d'échantillonnage 14 est à son niveau actif, sur le premier front actif de l'horloge de base. Cela signifie que le n^{ème} front actif de l'horloge de base correspond à une valeur n-1 du compteur 30.

Le comparateur 32 compare la sortie du compteur 30 à la valeur n-1 (qui est programmée en fonction de la fréquence F_{b} de l'horloge de base 26 et de la fréquence d'échantillonnage Fₛ). Lorsque le compteur arrive à n-1, la sortie 40 du comparateur 32 est désactivée. L'horloge de fonctionnement 22 est maintenue à son niveau inactif jusqu'à ce que l'horloge d'échantillonnage 14 passe à son niveau actif, et qu'un front montant de l'horloge de base 26 se produise.

Dans l'exemple décrit ici, les fronts actifs sont des fronts montants, les niveaux actifs sont des niveaux hauts, et les niveaux inactifs sont des niveaux bas.

Sur la figure 4 on a représenté un schéma d'un système de communication selon l'invention. Ce système de communication comporte un émetteur 50, un récepteur 55 et un média de transmission 58. Le récepteur 55 est du type de celui représenté sur la figure 1. Le média de transmission peut être de différentes natures. Il peut s'agir par exemple d'une transmission par câble, par satellite, ou d'une transmission hertzienne.

## Revendications

1. Système de communication comportant au moins un émetteur et un récepteur, ledit récepteur comportant:
- un convertisseur analogique - numérique (10) pour échantillonner un signal d'entrée (12) à un rythme fourni par une horloge d'échantillonnage (14),
- un processeur pour traiter des données échantillonnées (19), à un rythme fourni par une horloge de fonctionnement (22),
- un générateur d'horloge (20) pour générer ladite horloge de fonctionnement en fonction de l'horloge d'échantillonnage,
**caractérisé en ce que** ledit générateur comporte des moyens pour générer ladite horloge de fonctionnement à partir d'une horloge de base (26) de manière à ce que ladite horloge de fonctionnement ait un nombre entier constant (n) de périodes actives (Tₐ) pendant un cycle (Cₛ) de l'horloge d'échantillonnage.

2. Système de communication selon la revendication 1, **caractérisé en ce que** le générateur d'horloge comporte des moyens pour déterminer ledit nombre entier à partir de la partie entière du rapport entre les fréquences de l'horloge de base (F_{b}) et de l'horloge d'échantillonnage (Fₛ).

3. Récepteur comportant au moins:
- un convertisseur analogique - numérique (10) pour échantillonner un signal d'entrée (12) à un rythme fourni par une horloge d'échantillonnage (14),
- un processeur pour traiter des données échantillonnées (19), à un rythme fourni par une horloge de fonctionnement (22),
- un générateur d'horloge (20) pour générer ladite horloge de fonctionnement en fonction de l'horloge d'échantillonnage,
**caractérisé en ce que** ledit générateur comporte des moyens pour générer ladite horloge de fonctionnement à partir d'une horloge de base (26) de manière à ce que ladite horloge de fonctionnement ait un nombre entier constant (n) de périodes actives (Tₐ) pendant un cycle (Cₛ) de l'horloge d'échantillonnage.

4. Récepteur selon la revendication 3, **caractérisé en ce que** le générateur d'horloge comporte des moyens pour déterminer ledit nombre entier à partir de la partie entière du rapport entre les fréquences de l'horloge de base (F_{b}) et de horloge d'échantillonnage (Fₛ).

5. Dispositif de traitement de données numériques (19) préalablement échantillonnées à un rythme fourni par une horloge d'échantillonnage (14), comportant un générateur d'horloge (20) pour générer, en fonction de ladite horloge d'échantillonnage, une horloge de fonctionnement (22) destinée à être utilisée pour traiter lesdites données, **caractérisé en ce que** ledit générateur comporte des moyens pour générer ladite horloge de fonctionnement à partir d'une horloge de base (26) de manière à ce que ladite horloge de fonctionnement ait un nombre entier constant (n) de périodes actives (Tₐ) pendant un cycle de l'horloge d'échantillonnage (Cₛ).

6. Dispositif de traitement de données numériques selon la revendication 5, **caractérisé en ce que** le générateur d'horloge comporte des moyens pour déterminer ledit nombre entier à partir de la partie entière du rapport entre les fréquences de l'horloge de base (F_{b}) et de l'horloge d'échantillonnage (Fₛ).

## Patentansprüche

1. Kommunikationssystem mit mindestens einem Sender und einem Empfänger, wobei der besagte Empfänger enthält:
- einen Analog-Digital-Wandler (10) zum Abtasten eines Eingangssignals (12) mit einem von der Abtastuhr (14) gelieferten Takt,
- einen Prozessor zum Verarbeiten der abgetasteten Daten (19) mit einem von der Funktionsuhr (22) gelieferten Takt,
- einen Uhrgenerator (20) zum Erzeugen der besagten Funktionsuhr unter Berücksichtigung der Abtastuhr,
**dadurch gekennzeichnet, dass** der besagte Generator Mittel enthält, um die besagte Funktionsuhr anhand einer Basisuhr (26) derart zu generieren, dass die besagte Funktionsuhr eine konstante Ganzzahl (n) von aktiven Perioden (Tₐ) während einem Abtastuhrzyklus (Cₛ) hat.

2. Kommunikationssystem nach Anspruch 1, **dadurch gekennzeichnet, dass** der Uhrgenerator Mittel zur Bestimmung der besagten Ganzzahl anhand des Ganzteils der Relation mit den Basisuhrfrequenzen (F_{b}) und der Abtastuhr (Fₛ) enthält.

3. Empfänger mit mindestens:
- einem Analog-Digital-Wandler (10) zum Abtasten eines Eingangssignals (12) mit einem von der Abtastuhr (14) gelieferten Takt,
- einem Prozessor zum Verarbeiten der abgetasteten Daten (19) mit einem von der Funktionsuhr (22) gelieferten Takt,
- einem Uhrgenerator (20) zum Erzeugen der besagten Funktionsuhr unter Berücksichtigung der Abtastuhr,
**dadurch gekennzeichnet, dass** der besagte Generator Mittel enthält, um die besagte Funktionsuhr anhand einer Basisuhr (26) derart zu generieren, dass die besagte Funktionsuhr eine konstante Ganzzahl (n) von aktiven Perioden (Tₐ) während einem Abtastuhrzyklus (Cₛ) hat.

4. Empfänger nach Anspruch 3, **dadurch gekennzeichnet, dass** der Uhrgenerator Mittel zur Bestimmung der besagten Ganzzahl anhand des Ganzteils der Relation mit den Basisuhrfrequenzen (F_{b}) und der Abtastuhr (Fₛ) enthält.

5. Digitale Datenverarbeitungsvorrichtung (19), welche zuvor mit einem von einer Abtastuhr (14) gelieferten Takt abgetastet wurde und einen Uhrgenerator (20) enthält, um unter Berücksichtigung der besagten Abtastuhr eine dafür bestimmte Funktionsuhr (22) zu generieren, um zur Verarbeitung der besagten Daten verwendet zu werden, **dadurch gekennzeichnet, dass** der besagte Generator Mittel enthält, um die besagte Funktionsuhr anhand einer Basisuhr (26) derart zu generieren, dass die besagte Funktionsuhr eine konstante Ganzzahl (n) von aktiven Perioden (Tₐ) während einem Abtastuhrzyklus (Cₛ) hat.

6. Digitale Datenverarbeitungsvorrichtung nach Anspruch 5, **dadurch gekennzeichnet, dass** der Uhrgenerator Mittel zur Bestimmung der besagten Ganzzahl anhand des Ganzteils der Relation mit den Basisuhrfrequenzen (F_{b}) und der Abtastuhr (Fₛ) enthält.

## Claims

1. A communication system comprising at least a transmitter and a receiver, which receiver comprises:
- an analog/digital converter (10) for sampling an input signal (12) at a frequency supplied by a sampling clock (14),
- a processor for processing sampled data (19) at a frequency provided by an operational clock (22),
- a clock generator (20) for generating said operational clock as a function of the sampling clock,
**characterized in that** said generator comprises means for generating said operational clock from a basic clock (26) such that said operational clock has a constant integer number (n) of active periods (Tₐ) during one cycle (Cₛ) of the sampling clock.

2. A communication system as claimed in claim 1, **characterized in that** the clock generator comprises means for determining said integer number from the integer part of the ratio between the frequencies of the basic clock (F_{b}) and the sampling clock (Fₛ).

3. A receiver comprising at least:
- an analog/digital converter (10) for sampling an input signal (12) at a frequency supplied by a sampling clock (14),
- a processor for processing sampled data (19) at a frequency provided by an operational clock (22),
- a clock generator (20) for generating said operational clock as a function of the sampling clock,
**characterized in that** said generator comprises means for generating said operational clock from a basic clock (26) such that said operational clock has a constant integer number (n) of active periods (Tₐ) during one cycle (Cₛ) of the sampling clock.

4. A receiver as claimed in claim 3, **characterized in that** the clock generator comprises means for determining said integer number from the integer part of the ratio between the frequencies of the basic clock (F_{b}) and the sampling clock (Fₛ).

5. A processing device for digital data (19) which were previously sampled at a frequency provided by a sampling clock (14), which device comprises a clock generator (20) for generating an operational clock (22), which is to be used for processing said data, as a function of said sampling clock, **characterized in that** said generator comprises means for generating said operational clock from a basic clock (26) such that said operational clock has a constant integer number (n) of active periods (Tₐ) during one cycle (Cₛ) of the sampling clock.

6. A processing device for digital data as claimed in claim 5, **characterized in that** the clock generator comprises means for determining said integer number from the integer part of the ratio between the frequencies of the basic clock (F_{b}) and the sampling clock (Fₛ).
